# EUROPEAN PATENT APPLICATION

(11) **EP 4 791 141 A2**
(43) Date of publication of application: **12.08.2026**
(21) Application number: 26187619.7
(22) Date of filing: 04.01.2023
(51) Int. Cl.: H10B 12/00

(54) **MANUFACTURING METHOD FOR AND STRUCTURE OF SEMICONDUCTOR STRUCTURE**

(30) Priority: 11.11.2022 CN 202211412071
(62) Document number(s) of the earlier application(s) in accordance with Art. 76 EPC: 23887256.8 / 4 514 089
(71) Applicant: CXMT Corporation, Hefei, Anhui 230601 (CN)
(72) Inventor: Xiao, Deyuan, Hefei, Anhui 230601 (CN); Jiang, Yi, Hefei, Anhui 230601 (CN)
(74) Representative: Gulde & Partner

(57) **Abstract**

A manufacturing method for and a structure of a semiconductor structure are provided. The manufacturing method for a semiconductor structure includes the steps as follows. A substrate is provided. A first semiconductor layer and a second semiconductor layer that are sequentially stacked are formed on the substrate, a material of the first semiconductor layer being different from a material of the second semiconductor layer. The second semiconductor layer is etched to form active pillars arranged in an array in a first direction and a second direction, the active pillar including a first doped region, a channel region, and a second doped region sequentially arranged in a direction from the first semiconductor layer to the second semiconductor layer. Word line structures are formed, the word line structures surrounding the channel region, extending in the first direction, and being spaced apart in the second direction. Capacitor structures are formed, the capacitor structures being in contact with and connected to the second doped region. The substrate and the first semiconductor layer are removed to expose bottom surfaces of the active pillars. Bit line structures are formed, the bit line structures being in contact with and connected to the first doped region. The reliability of the semiconductor structure can be improved.

## Description

### CROSS-REFERENCE TO RELATED APPLICATIONS

The present disclosure claims priority to Chinese Patent Application No. 202211412071.3, filed on November 11, 2022 and entitled "MANUFACTURING METHOD FOR AND STRUCTURE OF A SEMICONDUCTOR STRUCTURE".

### TECHNICAL FIELD

Embodiments of the present disclosure relate to the semiconductor field, and in particular, to a manufacturing method for and a structure of a semiconductor structure.

### BACKGROUND

A memory is a memory component configured to store a program and various types of data information. Generally, random access memories (RAM) used by computer systems may be classified into two types: a dynamic random access memory (DRAM) and a static random access memory (SRAM). The dynamic random access memory is a semiconductor storage device commonly used in computers, and includes many repeated storage cells.

The storage cell usually includes a capacitor device and a transistor. A drain of the transistor is connected to a bit line structure, and a source is connected to the capacitor device. A capacitor contact structure and a capacitor are included in the capacitor device. Opening or closing of a channel region of the transistor can be controlled by a word line structure of the storage unit, so as to read, through the bit line structure, data information stored in the capacitor device, or write data information into the capacitor device through the bit line structure for storage. Related technology is known from CN114373720A, US20200312815A1, US20210118890A1 and US20200328186A1.

However, it is necessary to improve the reliability of a formed semiconductor structure.

### SUMMARY

In embodiments of the present disclosure, a manufacturing method for and a structure of a semiconductor structure are provided, to at least improve the reliability of a formed semiconductor structure. The invention is defined by the independent claims.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.

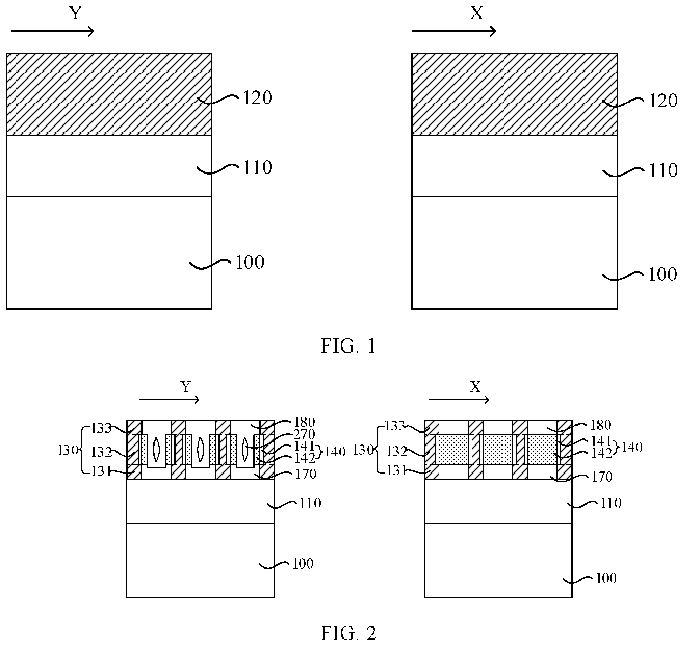

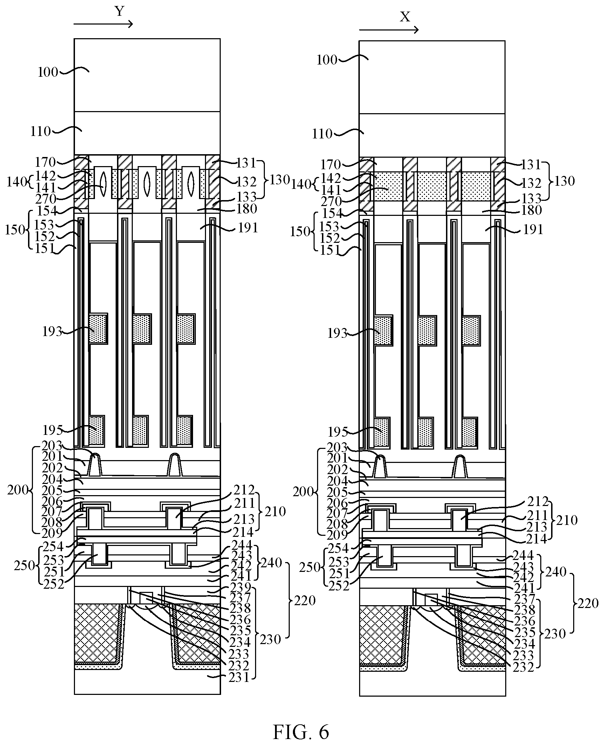

FIG. 1 to FIG. 8 are schematic diagrams of structures corresponding to steps of a manufacturing method for a semiconductor structure according to an embodiment of the present disclosure.

### DESCRIPTION OF EMBODIMENTS

A manufacturing method for a semiconductor structure is provided in embodiments of the present disclosure. A first semiconductor layer and a second semiconductor layer that are stacked are formed on a surface of a substrate, and active pillars are formed by etching the second semiconductor layer, so that the heights of the formed active pillars are controllable, and the uniformity of the formed active pillars can be ensured. A word line structure surrounding a channel region and a capacitor structure in contact with and connected to a second doped region are formed, the word line structure is configured to control whether to transmit data information to the capacitor structure or whether to read data information in the capacitor structure, and the capacitor structure is configured to store data information. Then, the substrate and the first semiconductor layer are removed, and a bit line structure is formed on a bottom surface of the active pillar, so that difficulty in forming the bit line structure can be further reduced.

The embodiments of the present disclosure are described in detail below with reference to the accompanying drawings. However, it may be understood by a person of ordinary skill in the art that in the embodiments of the present disclosure, many technical details are provided to enable readers to better understand the present disclosure. However, the technical solutions claimed in the present disclosure may be implemented even without these technical details and various changes and modifications made based on the following embodiments.

FIG. 1 to FIG. 8 are schematic diagrams of structures corresponding to steps of a manufacturing method for a semiconductor structure according to an embodiment of the present disclosure.

In some embodiments, a manufacturing method for a semiconductor structure may include the steps as follows. A substrate 100 is provided. A first semiconductor layer 110 and a second semiconductor layer 120 that are sequentially stacked are formed on the substrate 100, a material of the first semiconductor layer 110 being different from a material of the second semiconductor layer 120. The second semiconductor layer 120 is etched to form active pillars 130 arranged in an array in a first direction X and a second direction Y, the active pillar 130 including a first doped region 131, a channel region 132, and a second doped region 133 sequentially arranged in a direction from the first semiconductor layer 110 to the second semiconductor layer 120. Word line structures 140 are formed, the word line structures 140 surrounding the channel region 132, extending in the first direction X, and being spaced apart in the second direction Y. Capacitor structures 150 are formed, the capacitor structures 150 being in contact with and connected to the second doped region 133. The substrate 100 and the first semiconductor layer 110 are removed to expose bottom surfaces of the active pillars 130. Bit line structures 160 are formed, the bit line structures 160 being in contact with and connected to the first doped region 131, being spaced apart in the first direction X, and extending in the second direction Y.

The first semiconductor layer 110 and the second semiconductor layer 120 that are stacked are formed on the substrate 100, to provide a basis for subsequently forming the active pillars 130. The material of the first semiconductor layer 110 is set to be different from that of the second semiconductor layer 120, so that the first semiconductor layer 110 can be used as an etching stopping layer for the second semiconductor layer 120. Therefore, the active pillars 130 can be formed by etching through the second semiconductor layer 120, the heights of the formed active pillars 130 are controllable, and the uniformity of subsequently formed active pillars 130 can be ensured. The word line structures 140 surrounding the channel region 132 are formed to control whether to conduct the active pillar 130, so as to control whether to transmit data information to the capacitor structure 150 or whether to read data information in the capacitor structure 150, and the capacitor structure 150 is formed and can be configured to store data information. The substrate 100 and the first semiconductor layer 110 are removed to expose the bottom surfaces of the active pillars 130, that is, to expose a surface of the first doped region 131, so that a process basis is provided for subsequently forming the bit line structures 160. The bit line structures 160 are formed on the bottom surfaces of the active pillars 130, so that process difficulty in forming the bit line structures 160 can be reduced, and the bit line structures 160 in good shapes can be formed. As such, the reliability of the semiconductor structure can be improved.

In some embodiments, a material of the substrate 100 may be a semiconductor material, e.g., silicon, or the material of the substrate 100 may be an insulating material, e.g., silicon nitride. The material of the substrate 100 may be a material that can be easily removed, so that time required for subsequent removal of the material of the substrate 100 can be reduced, and process time of entire process steps can be reduced.

In some embodiments, the material of the second semiconductor layer 120 may be different from the material of the first semiconductor layer 110. It may be understood that the second semiconductor layer 120 is subsequently used as a basis for etching to form the active pillars 130. The material of the first semiconductor layer 110 is controlled to be different from the material of the second semiconductor layer 120, so that the second semiconductor layer 120 may be used as the etching stopping layer for the first semiconductor layer 110. Etching of the second semiconductor layer 120 can be stopped when the second semiconductor layer 120 is etched and a surface of the first semiconductor layer 110 is exposed.

In some embodiments, the material of the first semiconductor layer 110 may include silicon germanium, and the material of the second semiconductor layer 120 may include silicon. The material of the first semiconductor layer 110 is controlled to be silicon germanium, so that it is convenient to form the second semiconductor layer 120 on the surface of the first semiconductor layer 110, that is, it is convenient to grow silicon on a surface of silicon germanium. In addition, a ratio of content of a germanium element to content of a silicon element in the first semiconductor layer 110 may be controlled, to control an etching selectivity ratio between the first semiconductor layer 110 and the second semiconductor layer 120.

In some embodiments, the material of the first semiconductor layer 110 may be another material, and the material of the second semiconductor layer 120 may be another material that can be used as a material of the active pillars.

In some embodiments, the material of the substrate 100 is silicon, and the material of the first semiconductor layer is silicon germanium. Similarly, the material of the substrate 100 is set to be silicon, so that it is convenient to form the first semiconductor layer 110 on a surface of the substrate 100.

As shown in FIG. 2, the second semiconductor layer 120 (refer to FIG. 1) is etched to form the active pillars 130.

In some embodiments, the first doped region 131, the channel region 132, and the second doped region 133 of the active pillar 130 may be doped with doping ions of the same type, and doping concentrations of the doping ions may be the same, that is, a device formed by the active pillars 130 is a junctionless transistor (Junctionless Transistor). "junctionless" herein means no PN junctions, that is, no PN junction is included in a transistor formed by the active pillars 130. The following advantages are included: On the one hand, the first doped region 131, the channel region 132, and the second doped region 133 do not need to be additionally doped. As such, a problem that a doping process of the first doped region 131, the channel region 132, and the second doped region 133 is difficult to control can be avoided. Especially, as a transistor size is further reduced, doping concentrations are more difficult to control if the first doped region 131 and the second doped region 133 are additionally doped. On the other hand, because the device is a junctionless transistor, it helps avoid a phenomenon of making an ultra-steep PN junction within a nanoscale range with the use of an ultra-steep source/drain concentration gradient doping process. Therefore, problems such as threshold voltage drift and an increase in a leakage current that are caused by doping mutation can be avoided. In addition, a short channel effect is suppressed, and working can still be performed in a range of several nanometers. As such, integration density and electrical performance of the semiconductor structure can be further improved. It may be understood that additional doping herein means doping performed to make doping ion types of the first doped region 131 and the second doped region 133 different from a doping ion type of the channel region 132.

The second semiconductor layer 120 (as shown in FIG. 1) may be etched to form the active pillars 130, so that the thickness of the formed second semiconductor layer 120 can be controlled to control the height of the formed active pillars 130, and the second semiconductor layer 120 may be etched through to control all formed active pillars 130 to be the same in height. As such, the uniformity of the formed active pillars 130 can be ensured.

Still as shown in FIG. 2, the step as follows is further included. Word line structures 140 are formed, the word line structures 140 surrounding the channel region 132.

In some embodiments, a method for forming the word line structures 140 may include the steps as follows. Gate dielectric layers 141 are formed, the gate dielectric layers 141 surrounding the channel region 132 and being in contact with and connected to the active pillar 130. A word line conductive layer 142 is formed, the word line conductive layer 142 covering a surface of the gate dielectric layers 141. The gate dielectric layer 141 may be formed to avoid direct contact between the word line conductive layer 142 and the active pillar 130, so as to prevent carriers in the active pillar 130 from flowing to the word line conductive layer 142. The word line conductive layer 142 may be formed to control whether to conduct the active pillars 130, that is, control whether to output data information to the capacitor structure or whether to read data information in the capacitor structure.

In some embodiments, a method for forming the gate dielectric layer 141 may be a manner of oxidizing some active pillars 130, and a gate dielectric layer 141 formed through oxidization is better in compactness. In some embodiments, the method for forming the gate dielectric layer 141 may be alternatively an atomic vapor deposition manner, and a gate dielectric layer 141 formed through atomic vapor deposition is better in uniformity.

In some embodiments, a method for forming the word line conductive layer 142 may include the steps as follows. Initial word line conductive layers (not shown in the figure) are formed, the initial word line conductive layers filling gaps between the active pillars 130 arranged in an array. The initial word line conductive layers are etched, to form word line conductive layers 142 that extend in the first direction X and are spaced apart in the second direction Y. In a manner of forming before etching, process difficulty for the manufacturing method for the semiconductor structure can be reduced. In some embodiments, a trench configured to fill in the word line conductive layer may be formed first, and then the word line conductive layer is directly formed through filling.

In some embodiments, before the gate dielectric layer 141 is formed, the step as follows is further included. A first isolation layer 170 is formed. The first isolation layer is located between active pillars 130 arranged in an array, and is located on a sidewall of the first doped region 131. The first isolation layer 170 is formed, so that an electrical connection between the word line conductive layer 142 and a subsequently formed bit line structure can be avoided. As such, the reliability of the semiconductor structure can be improved.

In some embodiments, after the word line conductive layer 142 is formed, the step as follows may be further included. A second isolation layer 180 is formed. The second isolation layer 180 is located between adjacent word line conductive layers 142, or may be located on a top surface of the word line conductive layer 142. The second isolation layer 180 between adjacent word line conductive layers 142 may be configured to isolate the adjacent word line conductive layers 142, so that an electrical connection between the adjacent word line structures 140 can be avoided. As such, the reliability of the semiconductor structure can be improved. The second isolation layer 180 located on the top surface of the word line conductive layer 142 may be used as a protection layer for the word line structure 140, so that the word line conductive layer 142 can be prevented from being contaminated or damaged in subsequent process steps. As such, the reliability of the formed semiconductor structure can be improved.

It may be understood that, some first isolation layers 170 are inevitably etched when word line structures 140 spaced apart from each other are subsequently formed through etching. Therefore, grooves are formed in some first isolation layers 170. Therefore, bottom surfaces of some second isolation layers 180 are further lower than a top surface of the word line structure 140 when the second isolation layer 180 is formed.

In some embodiments, some second isolation layers 180 may be alternatively etched to form first air gaps 270 in the second isolation layers 180. The first air gaps 270 are formed, so that parasitic capacitance between adjacent word line structures 140 can be reduced. As such, the reliability of the semiconductor structure can be improved.

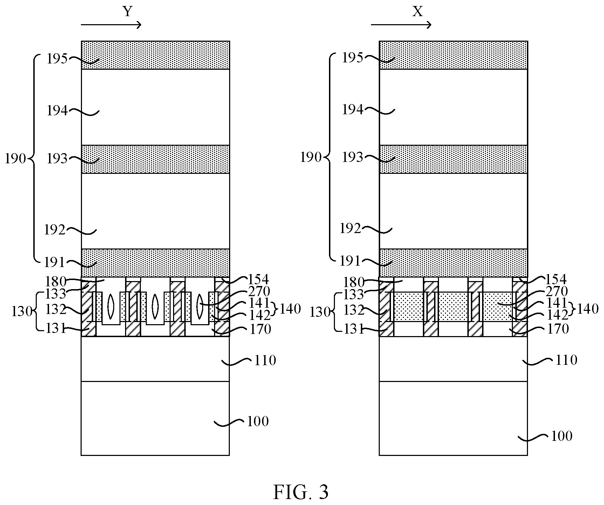

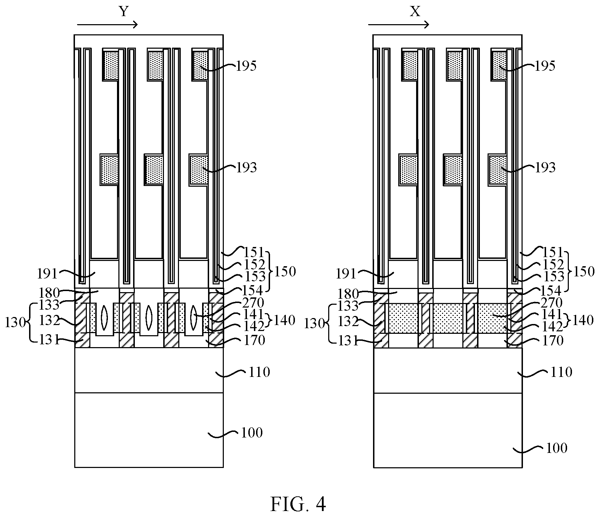

As shown in FIG. 3 and FIG. 4, the capacitor structures 150 are formed.

In some embodiments, a method for forming the capacitor structure 150 may include the steps as follows. A lower electrode plate 151 is formed, the lower electrode plate 151 being connected to a top surface of the second doped region 133. A capacitor dielectric layer 152 is formed, the capacitor dielectric layer 152 covering a surface of the lower electrode plate 151. An upper electrode plate 153 is formed, the upper electrode plate 153 covering a surface of the capacitor dielectric layer 152.

A material of the lower electrode plate 151 may include any one of or any combination of metal materials such as titanium nitride, tantalum nitride, copper, or tungsten. A material of the capacitor dielectric layer 152 may include any one of or any combination of ZrO, AlO, ZrNbO, ZrHfO, and ZrAlO. A material of the upper electrode plate 153 includes a compound formed by one or both of metal nitride and metal silicide, such as titanium nitride, titanium silicide, nickel silicide, titanium silicon nitride, or another conductive material, or the material of the upper electrode plate 153 may be a conductive semiconductor material, such as polysilicon or germanium silicon.

It may be understood that a relative area between the lower electrode plate 151 and the upper electrode plate 153 of the capacitor structure 150, a distance between the lower electrode plate 151 and the upper electrode plate 153, and the material of the capacitor dielectric layer 152 may affect a capacity of the capacitor structure 150. Therefore, the relative area between the lower electrode plate 151 and the upper electrode plate 153 of the capacitor structure 150, the distance between the lower electrode plate 151 and the upper electrode plate 153, and the material of the capacitor dielectric layer 152 may be set according to an actual requirement.

In some embodiments, a method for forming the capacitor structure 150 may include the steps as follows. A stacked structure 190 is formed, the stacked structure including a first support layer 191, a first sacrificial layer 192, a second support layer 193, a second sacrificial layer 194, and a third support layer 195 that are sequentially stacked. The stacked structure 190 is etched for the first time to form a first groove exposing the top surface of the second doped region 133. The lower electrode plate 151 is formed, the lower electrode plate 151 being located on a sidewall of the first groove and the top surface of the second doped region 133. The stacked structure 190 is etched for the second time, a part of the third support layer 195 is etched to expose a surface of the second sacrificial layer 194, and the second sacrificial layer 194 is removed to expose a surface of the second support layer 193. The stacked structure is etched for the third time, a part of the second support layer 193 is etched to expose a surface of the first sacrificial layer 192, and the first sacrificial layer 192 is removed to form a second groove exposing a partial sidewall of the lower electrode plate 151. The capacitor dielectric layer 152 is formed. The upper electrode plate 153 is formed.

A part of the first support layer 191, a part of the second support layer 193, and a part of the third support layer 195 are reserved, so that the lower electrode plate 151 can be prevented from collapsing in process steps of forming the capacitor structure 150. As such, the reliability of the formed capacitor structure 150 can be improved.

In some embodiments, materials of the first support layer 191, the second support layer 193, and the third support layer 195 may be the same, and may be titanium nitride; and materials of the first sacrificial layer 192 and the second sacrificial layer 194 may be the same, and may be silicon oxide or the like.

In some embodiments, materials of the first support layer 191, the first sacrificial layer 192, the second support layer 193, the second sacrificial layer 194, and the third support layer 195 may be mutually different, or materials of some film layers are the same.

It may be understood that the capacitor structure 150 formed in the foregoing process steps is a "cylindrical capacitor", and the cylindrical capacitor herein means that a shape of a structure of the formed lower electrode plate 151 is similar to a cylindrical shape.

In some embodiments, the capacitor structure may be alternatively a "columnar capacitor", that is, a shape of the lower electrode plate of the capacitor structure is not a cylindrical or U-shaped structure, but a cylindrical structure. A method for forming the "columnar capacitor" may include the steps as follows. A groove defining a shape of the lower electrode plate is directly formed, a material of the lower electrode plate is filled into the groove, a capacitor dielectric layer covering a surface of the lower electrode plate is then formed, and the upper electrode plate covering a surface of the capacitor dielectric layer is finally formed.

In some embodiments, before the stacked structure is formed, the step as follows may be further included. A capacitor contact structure 154 is formed. Direct contact between the active pillar 130 and the lower electrode plate 151 can be avoided through forming of the capacitor contact structure 154, so that a large material attribute difference between the lower electrode plate 151 and the active pillar 130 is prevented, and transmission of carriers is prevented from being affected.

In some embodiments, a method for forming the capacitor contact structure 154 may include the step as follows. Some active pillars 130 are metalized through a metal silicification process to form the capacitor contact structure 154.

In some embodiments, a method for forming the capacitor contact structure 154 may include the step as follows. A material of the capacitor contact structure is deposited on a surface of the active pillar 130 to form the capacitor contact structure.

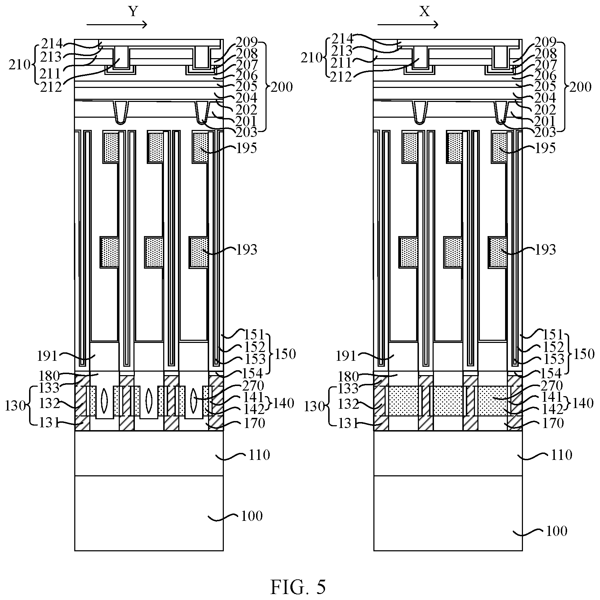

As shown in FIG. 5 to FIG. 7, the substrate 100 and the first semiconductor layer 110 are removed.

In some embodiments, before the substrate 100 and the first semiconductor layer 110 are etched, the steps as follows may be further included. A first interconnection structure 200 is formed, the first interconnection structure 200 being located on a top surface of the capacitor structure 150. A first pad structure 210 is formed, the first pad structure 210 being located on a top surface of the first interconnection structure 200. A chip 220 is provided, a second pad structure 250 being disposed on the chip 220. The chip 220 is bonded to the capacitor structure 150, the first pad structure 210 being in contact with and connected to the second pad structure 250.

In some embodiments, the first interconnection structure 200 and the first pad structure 210 may be configured to come into contact with and be electrically connected to the chip 220, and the chip 220 may be configured to provide a peripheral control circuit, to control whether to read data information in the capacitor structure 150 or input data information to the capacitor structure 150.

In some embodiments, a method for forming the first interconnection structure 200 includes the steps as follows. A first dielectric layer 201 is formed, the first dielectric layer 201 being located on a surface of the upper electrode plate 153. The first dielectric layer 201 is etched, and a first barrier layer 202 and a first conductive pillar 203 are formed, the first barrier layer 202 being located on a surface of the first conductive pillar 203, and the first conductive pillar 203 penetrating the first dielectric layer 201 and being electrically connected to the upper electrode plate 153. A first conductive layer 204 is formed, the first conductive layer 204 being located on a top surface of the first conductive pillar 203. A third isolation layer 205 is formed, the third isolation layer 205 being located on a top surface of the first conductive layer 204. A second dielectric layer 206 is formed, the second dielectric layer 206 being located on a top surface of the third isolation layer 205. The second dielectric layer 206 is etched, and a second barrier layer 207 and a second conductive layer 208 are formed, the second barrier layer 207 being located on a surface of the second conductive layer 208, and the second conductive layer 208 being located in the second dielectric layer 206. A fourth isolation layer 209 is formed, the fourth isolation layer 209 being located on a surface of the second dielectric layer 206.

In some embodiments, materials of the first dielectric layer 201 and the second dielectric layer 206 may be the same, and may be insulating materials such as silicon oxide; materials of the first barrier layer 202 and the second barrier layer 207 may be the same, and may be titanium nitride; a material of the first conductive pillar 203 may be metal such as copper or tungsten; materials of the first conductive layer 204 and the second conductive layer 208 may be metal such as copper or tungsten; and materials of the third isolation layer 205 and the fourth isolation layer 209 may be the same, and may be insulating materials such as silicon nitride.

In some embodiments, a method for forming the first pad structure 210 may include the steps as follows. A third dielectric layer 211 is formed, the third dielectric layer 211 being located on a surface of the fourth isolation layer 209. The fourth isolation layer 209 and the third dielectric layer 211 are etched to expose a part of a surface of the second conductive layer 208. A second conductive pillar 212 and a third barrier layer 213 are formed, the third barrier layer 213 being located on a surface of the second conductive pillar 212, and the second conductive pillar 212 being embedded into the third dielectric layer 211 and electrically connected to the second conductive layer 208. A first pad 214 is formed, the first pad 214 being located on a top surface of the second conductive pillar 212, and the third barrier layer 213 further covering a part of a surface of the first pad facing the first interconnection structure 200.

In some embodiments, a material of the third dielectric layer 211 may be silicon oxide; a material of the second conductive pillar 212 may be metal such as tungsten or copper; a material of the third barrier layer 213 may be titanium nitride or the like; and a material of the first pad 214 may be metal such as copper.

In some embodiments, the chip 220 includes: a control circuit structure 230; a second interconnection structure 240, the second interconnection structure 240 being located on a top surface of the control circuit structure 230; and a second pad structure 250, the second pad structure 250 being located on a surface of the second interconnection structure 240 away from the control circuit structure 230, and the second pad structure 250 being in contact with and connected to the first pad structure 210.

In some embodiments, the control circuit structure 230 may include: an active structure 231, the active structure 231 including a third doped region 232, a second channel region 233, and a fourth doped region 234, the active structure 231 including a gate structure 235, and the gate structure 235 being in contact with and connected to the second channel region 233; a gate protection layer 238, the gate protection layer 238 being located on a surface of the gate structure 235; a first lead-out structure 236, the first lead-out structure 236 being in contact with and connected to the third doped region 232; a second lead-out structure 237, the second lead-out structure 237 being in contact with and connected to the fourth doped region 234, and the first lead-out structure 236 being spaced apart from the second lead-out structure 237; and a fourth dielectric layer 239, the fourth dielectric layer 239 being located on a top surface of the active structure 231.

In some embodiments, the second interconnection structure 240 may include: a third conductive layer 241, the third conductive layer 241 being located on a top surface of the fourth dielectric layer 239 and being electrically connected to the first lead-out structure 236 and the second lead-out structure 237; a fifth dielectric layer 242, the fifth dielectric layer 242 being located on a top surface of the third conductive layer 241; a fourth conductive layer 243, the fourth conductive layer 243 being located in the fifth dielectric layer 242; and a fifth isolation layer 244, the fifth isolation layer 244 being located on a top surface of the fourth conductive layer 243.

In some embodiments, a method for bonding the first pad structure 210 and the second pad structure 250 includes the step as follows. A surface of the first pad structure 210 is directly bonded to a surface of the second pad structure 250. The strength of bonding between the chip 220 and the capacitor structure can be improved in the direct bonding manner.

In some embodiments, a bonding manner for the first pad structure 210 and the second pad structure 250 may be alternatively another manner, such as thermocompression bonding, metal diffusion bonding, or polymer bonding.

In some embodiments, the chip 220 further includes an isolation structure surrounding the active structure 231, that is, a shallow trench isolation (STI) structure.

In some embodiments, the gate structure 235 may further include a gate oxide layer, a semiconductor layer, and a metal layer that are sequentially stacked.

In some embodiments, the gate protection layer 238 may be a structure with multiple film layers, e.g., may include a nitride layer-oxide layer-nitride layer, that is, an NON structure.

In some embodiments, a diffusion barrier layer may be further formed on sidewalls of the first lead-out structure 236 and the second lead-out structure 237, to prevent metal ions of the first lead-out structure 236 and the second lead-out structure 237 from being diffused into the fourth dielectric layer 239.

In some embodiments, a diffusion barrier layer may be further formed between the third conductive layer 241 and the fourth dielectric layer 239, and a diffusion barrier layer may be further formed between the third conductive layer 241 and the fifth dielectric layer 242.

In some embodiments, a diffusion barrier layer may be further formed between the fourth conductive layer 243 and the fifth dielectric layer 242.

In some embodiments, the active structure 231 may be a silicon substrate. Doping ions of the third doped region 232 and the fourth doped region 234 are of the same type, and are different from doping ions of the second channel region 233. Materials of the first lead-out structure 236 and the second lead-out structure 237 may be metal. A material of the fourth dielectric layer 239 may be an insulating material such as silicon oxide. A material of the third conductive layer 241 may be a metal material such as tungsten or copper. A material of the fifth dielectric layer 242 may be an insulating material such as silicon oxide. A material of the fourth conductive layer 243 may be a metal material such as tungsten or copper. A material of the fifth isolation layer 244 may be an insulating material such as silicon nitride.

In some embodiments, a method for forming the second pad structure 250 includes the steps as follows. A sixth dielectric layer 251 is formed, the sixth dielectric layer 251 being located on a surface of the fifth isolation layer 244. The sixth dielectric layer 251 and the fifth isolation layer 244 are etched, and a fourth conductive pillar 252 and a fourth barrier layer 253 are formed, the fourth conductive pillar 252 being located in the sixth dielectric layer 251, penetrating the fifth isolation layer 244, and being electrically connected to the fourth conductive layer 243, and the fourth barrier layer 253 being located on a surface of the fourth conductive pillar 252. A second pad 254 is formed, the second pad 254 being located on a top surface of the fourth conductive pillar 252.

In some embodiments, a material of the sixth dielectric layer 251 may be an insulating material such as silicon oxide, a material of the fourth conductive pillar 252 may be a metal material such as tungsten or copper, a material of the fourth barrier layer 253 may be a material such as titanium nitride, and a material of the second pad 254 may be a metal material such as copper.

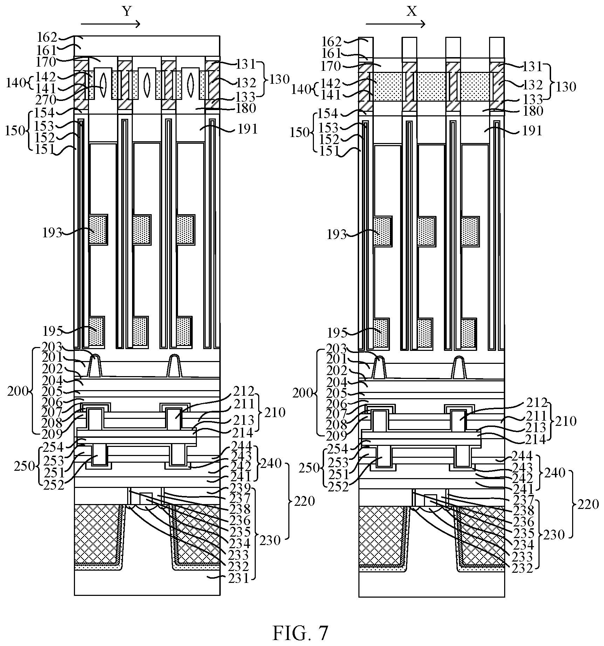

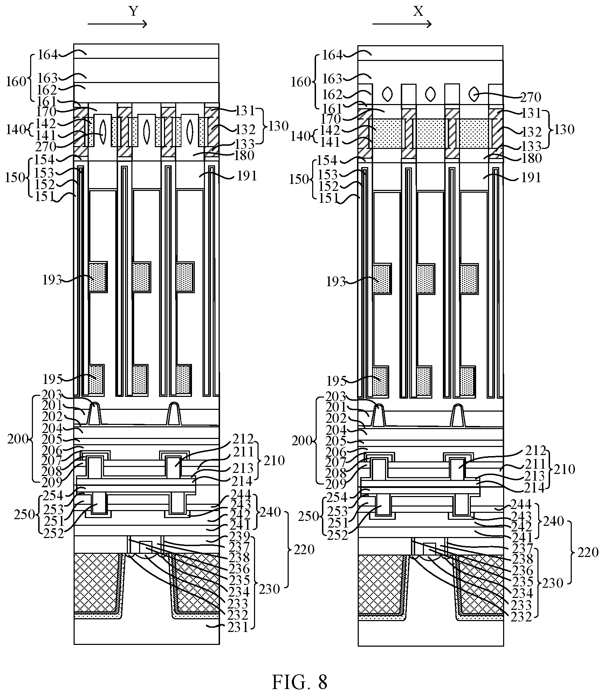

As shown in FIG. 7 and FIG. 8, the bit line structures 160 are formed.

In some embodiments, a method for forming the bit line structures 160 may include the steps as follows. Bit line conductive layers 162 are formed, the bit line conductive layer 162 being located on a side of the active pillars 130 away from the capacitor structures 150, and the bit line conductive layers 162 being spaced apart in the first direction X and extending in the second direction Y. A bit line protection layer 164 is formed, the bit line protection layer 164 being located on the bit line conductive layers 162. The bit line conductive layer 162 is configured to transmit data information, and the bit line protection layer 164 is formed to protect the bit line conductive layer 162.

In some embodiments, a method for forming the bit line conductive layer 162 may include the steps as follows. An initial bit line conductive layer is formed, the initial bit line conductive layer being located on a surface of the first doped region 131. The initial bit line conductive layer is etched, and the remaining initial bit line conductive layer is used as the bit line conductive layer. Process difficulty in forming the bit line conductive layer 162 can be reduced in a manner of performing depositing on an entire surface to form the initial bit line conductive layer before etching.

In some embodiments, a method for forming the bit line structures 160 further includes the step as follows. A bit line contact structure 161 is formed, the bit line contact structure 161 being located on a top surface of the first doped region 131. Contact resistance between the bit line structure 160 and the active pillar 130 can be reduced with the formed bit line contact structure 161.

In some embodiments, a method for forming the bit line contact structure 161 may include the step as follows. The bit line contact structure 161 is formed in a manner of metallizing some first doped regions 131 with a metal silicification process.

In some embodiments, after the bit line conductive layer 162 is formed and before the bit line protection layer 164 is formed, the step as follows is further included. A bit line isolation layer 163 is formed. The bit line isolation layer 163 is located between adjacent bit line conductive layers 162, and further covers a top surface of the bit line conductive layer 162, and the bit line protection layer 164 may be further located on a top surface of the bit line isolation layer 163. Adjacent bit line conductive layers 162 may be isolated with the formed bit line isolation layer 163, so that a short circuit between the adjacent bit line conductive layers 162 can be avoided.

In some embodiments, the step as follows may be further included. A second air gap 260 is formed. The second air gap 260 is located between adjacent bit line conductive layers 162. As such, parasitic capacitance between the adjacent bit line conductive layers 162 can be reduced, and the reliability of the semiconductor structure can be improved.

In this embodiment of the present disclosure, the first semiconductor layer 110 and the second semiconductor layer 120 that are stacked are formed on the substrate 100, to provide a basis for subsequently forming the active pillars 130. The material of the first semiconductor layer 110 is set to be different from that of the second semiconductor layer 120, so that the first semiconductor layer 110 can be used as the etching stopping layer for the second semiconductor layer 120. Therefore, the active pillars 130 may be formed by etching through the second semiconductor layer 120, the heights of the formed active pillars 130 are controllable, and the uniformity of subsequently formed active pillars 130 can be ensured. The word line structures 140 surrounding the channel region 132 are formed to conduct the active pillar 130, so as to control whether to transmit data information to the capacitor structure 150 or whether to read data information in the capacitor structure 150; the capacitor structure 150 is formed and can be configured to store data information. The substrate 100 and the first semiconductor layer 110 are removed to expose the bottom surfaces of the active pillars 130, that is, to expose the surface of the first doped region 131, so that a process basis is provided for subsequently forming the bit line structures 160. The bit line structures 160 are formed on the bottom surfaces of the active pillars 130, so that the process difficulty in forming the bit line structures 160 can be reduced, the bit line structures 160 in good shapes can be formed. As such, the reliability of the semiconductor structure can be improved.

In another embodiment of the present disclosure further, a semiconductor structure is further provided. The semiconductor structure may be formed with the foregoing manufacturing method for a semiconductor structure. The semiconductor structure provided in the another embodiment of the present disclosure is described below with reference to the accompanying drawings. It should be noted that, for a part that is the same as or corresponding to the foregoing embodiments, reference may be made to corresponding descriptions in the foregoing embodiments, and details are not described below.

As shown in FIG. 8, the semiconductor structure provided in this embodiment of the present disclosure includes: active pillars 130 arranged in an array in a first direction X and a second direction Y, the active pillar 130 including a first doped region 131, a channel region 132, and a second doped region 133 that are sequentially arranged; word line structures 140, the word line structures 140 surrounding the channel region 132, extending in the first direction X, and being spaced apart in the second direction Y; capacitor structures 150, the capacitor structures 150 being in contact with and connected to the second doped region 133; bit line structures 160, the bit line structures 160 being in contact with and connected to the first doped region 131, being spaced apart in the first direction X, and extending in the second direction Y; a first interconnection structure 200, the first interconnection structure 200 being located on a surface of the capacitor structure 150 away from the active pillar 130; a first pad structure 210, the first pad structure 210 being located on a surface of the first interconnection structure 200 away from the capacitor structure 150; and a chip 220, the chip 220 being in contact with and electrically connected to the first pad structure 210.

In this embodiment of the present disclosure, an electrical signal is provided by the chip 220, and the electrical signal provided by the chip 220 is transmitted to the semiconductor structure through the first pad structure 210 and the first interconnection structure 200. The word line structure 140 receives the electrical signal to control whether to conduct the active pillar 130, and the bit line structure 160 inputs data information into the capacitor structure 150 or exports data information in the capacitor structure 150 under the control of a signal from the word line structure 140.

In some embodiments, the chip 220 includes: a control circuit structure 230; a second interconnection structure 240, the second interconnection structure 240 being located on a top surface of the control circuit structure 230; and a second pad structure 250, the second pad structure 250 being located on a surface of the second interconnection structure 240 away from the control circuit structure 230, and the second pad structure 250 being in contact with and connected to the first pad structure 210. The control circuit structure 230 is used to control whether to transmit the electrical signal to the semiconductor structure, and the chip 220 is bonded to the first pad structure 210 through the second interconnection structure 240 and the second pad structure, so that a signal is provided to the word line structure 140, the bit line structure 160, and the capacitor structure 150.

In some embodiments, the control circuit structure 230 includes: an active structure 231, the active structure 231 including a third doped region 232, a second channel region 233, and a fourth doped region 234 arranged in the second direction Y; a gate structure 235, the gate structure 235 being in contact with and connected to the second channel region 233; a first lead-out structure 236, the first lead-out structure 236 being in contact with and connected to the third doped region 232; and a second lead-out structure 237, the second lead-out structure 237 being in contact with and connected to the fourth doped region 234, the first lead-out structure 236 being spaced apart from the second lead-out structure 237, and both the first lead-out structure 236 and the second lead-out structure 237 being in contact with and connected to the second interconnection structure 240. A signal from the third doped region 232 is led out or transmitted to the third doped region 232 through the first lead-out structure 236, a signal from the fourth doped region 234 is led out or transmitted to the fourth doped region 234 through the second lead-out structure 237, and flowing of carriers between the third doped region 232 and the fourth doped region 234 is controlled by the gate structure 235.

In some embodiments, in a direction in which the active pillars 130 face the capacitor structures 150, the active pillars 130 arranged in an array are equal in height, and the reliability of the semiconductor structure can be improved by controlling the active pillars 130 to be equal in height.

In some embodiments, the capacitor structure 150 may include: a lower electrode plate 151, the lower electrode plate 151 being in contact with and connected to a top surface of the second doped region 133; a capacitor dielectric layer 152, the capacitor dielectric layer 152 covering a surface of the lower electrode plate 151; and an upper electrode plate 153, the upper electrode plate 153 covering a surface of the capacitor dielectric layer 152. The lower electrode plate 151 is connected to the active pillar 130, so that the capacitor structure 150 and the active pillar 130 are electrically connected. The lower electrode plate 151 is separated from the upper electrode plate 153 by the capacitor dielectric layer 152. The upper electrode plate 153 directly faces the lower electrode plate 151, and a facing area is controlled to control a charge storage capacity of the capacitor structure 150.

In some embodiments, the capacitor structure 150 includes a capacitor contact structure 154 located on the top surface of the second doped region 133. The capacitor contact structure 154 is disposed, so that contact resistance between the capacitor structure 150 and the active pillar 130 can be reduced, and a possibility of transmission abnormality caused by a large material difference between the capacitor structure 150 and the active pillar 130 can be reduced.

In some embodiments, the lower electrode plate 151 is located on a top surface of the capacitor contact structure 154.

In some embodiments, the bit line structures 160 may include: bit line conductive layers 162, the bit line conductive layers 162 being located on a side of the active pillars 130 away from the capacitor structures 150, and the bit line conductive layers 162 being spaced apart in the first direction X and extending in the second direction Y; and a bit line protection layer 164, the bit line protection layer 164 being located on the bit line conductive layers 162. The bit line conductive layer 162 is disposed as a part used by the bit line structure 160 to transmit a signal, and the bit line protection layer 164 may be disposed to protect the bit line conductive layer 162. As such, the reliability of the bit line structure 160 can be improved.

In some embodiments, the bit line structure 160 may further include a bit line contact structure 161 located on a top surface of the first doped region 131, and contact resistance between the bit line structure 160 and the active pillar 130 can be reduced by disposing the bit line contact structure 161.

In some embodiments, the bit line conductive layer 162 is located on a side of the bit line contact structure 161 away from the capacitor structure 150.

In some embodiments, the semiconductor structure may further include a second air gap 260 located between adjacent bit line structures 160, and parasitic capacitance between the adjacent bit line structures 160 can be reduced by disposing the second air gap 260.

In some embodiments, the word line structure 140 may include a gate dielectric layer 141 and a word line conductive layer 142 located on a surface of the gate dielectric layer 141, and the word line conductive layer 142 surrounds the active pillar 130. The word line structure 140 surrounding the active pillar 130 is disposed, so that a capability of the word line structure 140 for controlling to conduct the active pillar 130 can be improved. As such, performance of the semiconductor structure is improved.

In some embodiments, a first air gap 270 located between adjacent word line structures 140 may be further included. As such, parasitic capacitance between adjacent word line structures 140 can be reduced, and the performance of the semiconductor structure can be improved.

In this embodiment of the present disclosure, an electrical signal is provided by the chip 220, and the electrical signal provided by the chip 220 is transmitted to the semiconductor structure through the first pad structure 210 and the first interconnection structure 200. The word line structure 140 receives the electrical signal to control whether to conduct the active pillar 130, and the bit line structure 160 inputs data information into the capacitor structure 150 or exports data information in the capacitor structure 150 under the control of a signal from the word line structure 140.

A person of ordinary skill in the art may understand that the foregoing implementations are specific embodiments for implementing the present disclosure. In actual application, various modifications may be made to the forms and details of the implementations without departing from the spirit and scope of the embodiments of the present disclosure. Any person skilled in the art may make changes and modifications without departing from the spirit and scope of the embodiments of the present disclosure. Therefore, the protection scope of the embodiments of the present disclosure shall be subject to the scope defined by the claims.

## Claims

1. A semiconductor structure, comprising:
active pillars(130) arranged in an array in a first direction and a second direction, the active pillar(130) comprising a first doped region(131), a channel region(132), and a second doped region(133) that are sequentially arranged;
word line structures(140), the word line structures(140) surrounding the channel region(132), extending in the first direction, and being spaced apart in the second direction;
capacitor structures(150), the capacitor structures(150) being in contact with and connected to the second doped region(133);
bit line structures(160), the bit line structures(160) being in contact with and connected to the first doped region(131), being spaced apart in the first direction, and extending in the second direction;
a first interconnection structure(200), the first interconnection structure(200) being located on a surface of the capacitor structure(150) away from the active pillar(130);
a first pad structure(210), the first pad structure(210) being located on a surface of the first interconnection structure(200) away from the capacitor structure(150); and
a chip(220), the chip(220) being in contact with and electrically connected to the first pad structure(210);
wherein the active pillars(130) arranged in an array are equal in height in a direction in which the active pillars(130) face the capacitor structures(150).

2. The semiconductor structure according to claim 1, wherein the chip(220) comprises:
a control circuit structure(230);
a second interconnection structure(240), the second interconnection structure(240) being located on a top surface of the control circuit structure(230); and
a second pad structure(250), the second pad structure(250) being located on a surface of the second interconnection structure(240) away from the control circuit structure(230), and the second pad structure(250) being in contact with and connected to the first pad structure(210).

3. The semiconductor structure according to claim 2, wherein the control circuit structure(230) comprises:
an active structure(231), the active structure(231) comprising a third doped region(232), a second channel region(233), and a fourth doped region(234) arranged in the second direction Y;
a gate structure(235), the gate structure(235) being in contact with and connected to the second channel region(233);
a first lead-out structure(236), the first lead-out structure(236) being in contact with and connected to the third doped region(232); and
a second lead-out structure(237), the second lead-out structure(237) being in contact with and connected to the fourth doped region(234), the first lead-out structure(236) being spaced apart from the second lead-out structure(237), and both the first lead-out structure(236) and the second lead-out structure(237) being in contact with and connected to the second interconnection structure(240).

4. The semiconductor structure according to claim 1, wherein the capacitor structure comprises:
a lower electrode plate(151), the lower electrode plate(151) being in contact with and connected to a top surface of the second doped region(133);
a capacitor dielectric layer(152), the capacitor dielectric layer(152) covering a surface of the lower electrode plate(151); and
an upper electrode plate(153), the upper electrode plate(153) covering a surface of the capacitor dielectric layer(152).

5. The semiconductor structure according to claim 1, wherein the bit line structure comprises:
bit line conductive layers(162), the bit line conductive layers(162) being located on a side of the active pillars(130) away from the capacitor structures(150), and the bit line conductive layers(162) being spaced apart in the first direction and extending in the second direction; and
a bit line protection layer(164), the bit line protection layer(164) being located on the bit line conductive layers(162).

6. The semiconductor structure according to claim 1, wherein the bit line structure further comprises a bit line contact structure(161) located on a top surface of the first doped region(131).

7. The semiconductor structure according to claim 1, wherein the capacitor structure further comprises a capacitor contact structure(154) located on a top surface of the second doped region(133).

8. The semiconductor structure according to claim 1, further comprising a first air gap(270) located between adjacent word line structures(140).

9. The semiconductor structure according to claim 1, further comprising a second air gap(260) located between adjacent bit line structures(160).

10. The semiconductor structure according to claim 1, wherein the first doped region (131), the channel region (132), and the second doped region (133) of the active pillar (130) are doped with doping ions of the same type.

11. The semiconductor structure according to claim 3, further comprising a diffusion barrier layer located on sidewalls of the first lead-out structure (236) and the second lead-out structure (237).

12. The semiconductor structure according to claim 9, further comprising a bit line isolation layer (163) located between adjacent bit line conductive layers (162), the second air gap(260) is located in the bit line isolation layer (163).

13. The semiconductor structure according to claim 8, further comprising a second isolation layer (180) located between adjacent word line conductive layers (142), or located on a top surface of the word line conductive layer (142).

14. The semiconductor structure according to claim 1, further comprising a first isolation layer (170) located between active pillars (130) arranged in an array, and located on a sidewall of the first doped region (131).

15. The semiconductor structure according to claim 1, further comprising a gate dielectric layers (141) surrounding the channel region (132) and being in contact with and connected to the active pillar (130).
